# EUROPEAN PATENT APPLICATION

(11) **EP 3 112 499 A1**
(43) Date of publication of application: **04.01.2017**
(21) Application number: 15754572.4
(22) Date of filing: 24.02.2015
(51) Int. Cl.: C23C 18/08, C23C 18/04

(54) **METHOD FOR METALLIZING DIELECTRIC SUBSTRATE SURFACE, AND DIELECTRIC SUBSTRATE PROVIDED WITH METAL FILM**

(30) Priority: 28.02.2014 JP 2014038876
(71) Applicant: Osaka University, Suita-shi, Osaka 565-0871 (JP); NOF Corporation, Shibuya-ku Tokyo 150-6019 (JP)
(72) Inventor: YAMAMURA Kazuya, Suita-shi Osaka 565-0871 (JP); OHKUBO Yuji, Suita-shi Osaka 565-0871 (JP); SATO Haruka, Suita-shi Osaka 565-0871 (JP); HIKITA Masaya, Tsukuba-shi Ibaraki 300-2635 (JP)
(74) Representative: Vossius & Partner Patentanwälte Rechtsanwälte mbB
(86) International application number: PCT/JP2015/055186
(87) International publication number: WO 2015/129675

(57) **Abstract**

A method includes: generating a peroxide radical on a dielectric substrate surface by treating the dielectric substrate surface with atmospheric pressure plasma using a rare gas; fixing a functional group forming a coordinate bond with a silver ion, by reacting a grafting agent; and applying a silver-containing composition to the substrate surface, followed by heating and curing the silver-containing composition, to thereby form a silver thin film layer, the silver-containing composition containing a silver compound (A) represented by Formula (1) and an amine compound (B) represented by Formula (2), the silver compound (A) being contained in an amount of 10 to 50% by mass, the amine compound (B) being contained in an amount of 50 to 90% by mass, relative to a total amount of 100% by mass of the silver compound (A) and the amine compound (B). The method enables to form a metal film having high adhesiveness even on the surface of a fluorine resin, which is suitable as a dielectric substrate due to its property of avoidance of delay in signal transmission speed or increase in power consumption, but has extremely low adhesiveness. [C. 1] 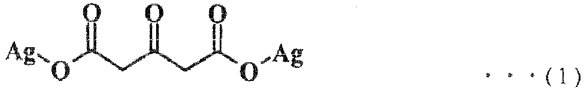 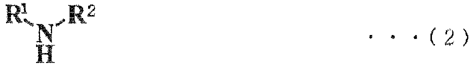 (R¹: a hydrogen atom, -(CY₂)a-CHₐ, or -((CH₂)b-O-CHZ)c-CH₃; R²: -(CY₂)d-CH₃ or -((CH₂)e-O-CHZ)f-CH₃; Y: a hydrogen atom or -(CH₂)g-CH₃; Z: a hydrogen atom or -(CH₂)h-CH₃; a: an integer of 0 to 8; b: an integer of 1 to 4; c: an integer of 1 to 3; d: an integer of 1 to 8; e: an integer of 1 to 4; f: an integer of 1 to 3; g: an integer of 1 to 3; h: an integer of 1 or 2)

## Description

### Technical Field

The present invention relates to a method for metallizing a dielectric substrate surface that serves as a dielectric substrate provided with a metal film used as a high-frequency device for cell phones, communication circuits, and the like, and to a dielectric substrate provided with a metal film produced by the method.

### Background Art

A method for metallizing a dielectric substrate surface is disclosed in Patent Document 1, for example. In the method, a silver-containing composition that contains a particular silver compound (A) and an amine compound (B) is applied onto a substrate composed of glass, silicon, a polyimide, a polyester, a polycarbonate, or the like, and the substrate is heated to form a metallic silver film or a silver film used for a silver wiring or the like. According to the method, a metallic silver film can be rapidly obtained in the absence of a catalyst at a low temperature of less than 150°C. A metallic silver film can be thus formed on a resin substrate having low heat resistance in a short time, for example. At a high temperature of 150°C or more, a metallic silver film can also be formed, in a short time. Accordingly, the productivity can be likely improved by the method. In addition, a metallic silver film obtained by the method has high flatness and adhesiveness to a substrate. Therefore, metallic silver films obtained by heating the aforementioned composition after a coating/printing process are likely to be used for various materials, such as wiring materials and reflection materials.

High-frequency devices used in cell phones, communication circuits, and the like have been developed to achieve the speeding-up of these devices by increasing an operating frequency and the reduction of power consumption. However, increase in speed of these devices unfortunately causes technical problems relating to wiring capacitance, such as a signal delay and an increase of the power consumption. To solve these problems, materials having lower dielectric constants than those of conventionally widely used polyimide insulating materials (a relative dielectric constant of 3.2 to 3.5) are required, and fluorine resins represented by polytetrafluoroethylene (hereinafter also abbreviated as PTFE) having a relative dielectric constant of 2.1 have been focused. The fluorine resin has extremely excellent chemical resistance, heat resistance, and electrical characteristics, in addition to excellent dielectric characteristics even in GHz bands, and thus can be applied, in place of polyimides, to high-frequency print substrates, receiving antennas for satellite broadcasting, and the like.

However, the fluorine resin has a low surface energy due to its high chemical stability and thus adhesion to other substance groups is extremely difficult for the fluorine resin. The silver-containing composition disclosed in Patent Document 1 has sufficient adhesiveness to substrates composed of glass, silicon, a polyimide, a polyester, a polycarbonate, or the like, but does not always have sufficient adhesiveness to such fluorine resins represented by PTFE, for which adhesion is extremely difficult to other substance groups because of its high chemical stability, as mentioned above. The adhesiveness is thus required to be improved.

Meanwhile, as a method for forming a metal film having excellent adhesiveness to substrates composed of such fluorine resins represented by PTFE as above, Patent Document 2 discloses a catalyst-free metallization method. The method includes a step of generating a hydrophilic functional group on a dielectric substrate surface by treating the dielectric substrate surface with atmospheric pressure plasma treatment using a rare gas; a step of applying a complexing polymer that has been polymerized and has a defined primary structure and a precursor containing the same metal species as that in an intended plated layer, to the surface of the dielectric substrate by a liquid phase method to form an ultrathin film; a step of grafting the complexing polymer at a high density by spontaneous formation of covalent bonds of the complexing polymer from the hydrophilic functional group as a reaction site, concurrently connecting the precursor to the complexing polymer through a coordinate bond, and then conducting atmospheric pressure plasma treatment on the complexing polymer film containing the metal ions, using a rare gas to reduce the metal ions into an atomic metal; and a step of allowing the formed atomic metal to aggregate in a self-organized manner to form a nanosized cluster, and then immersing the substrate in an electroless plating bath to form a metal layer using the metal nanocluster as a catalyst.

According to the catalyst-free metallization method, by treatment with non-equilibrium plasma generated by low electric power applied under atmospheric pressure and subsequent graft polymerization of a complexing polymer in a self-organized manner, a new uneven structure on the molecular level is formed on the fluorine resin substrate surface, and the grafted complexing polymer is directly connected to the precursor of a plating metal through coordinate bonds. Then, the precursor is reduced by atmospheric pressure plasma into an atomic metal, and the formed metal cluster functions as a catalyst in an electroless plating step. This allows autocatalytic reaction to proceed from the metal nanocluster as the starting point, forming a metal layer on the resin surface. Accordingly, the fluorine resin is connected to the complexing polymer and the complexing polymer is connected to the metal layer by strong multisite interaction through covalent bonds. The method therefore can achieve strong adhesive strength with the fluorine resin such as PTFE.

In addition to the above catalyst-free metallization method, another method that greatly improves the adhesiveness of a metal layer to the surface of a dielectric substrate and solves the problem of nonuniform adhesiveness is also disclosed. In the method, a complexing polymer is grafted at a high density by spontaneous formation of covalent bonds of the complexing polymer from a hydrophilic functional group as a reaction site, and then a precursor containing the same metal species as that in a plated layer is applied to the surface of a dielectric substrate by a liquid phase method. The method further includes, before the step of connecting the precursor to the complexing polymer through coordinate bonds, a step of previously washing and removing an unreacted complexing polymer that is not directly bonded to the dielectric substrate (see Patent Document 3).

According to the methods disclosed in Patent Documents 2 and 3, a metal film having excellent adhesiveness can be formed on the surface of a dielectric substrate composed of the fluorine resin for which adhesion is extremely difficult to other substance groups due to its high chemical stability. However, these methods require many steps. For example, the methods include the steps of subjecting the surface of a dielectric substrate to atmospheric pressure plasma treatment using a rare gas to introduce a hydrophilic functional group to the surface, applying a complexing polymer, grafting the complexing polymer at a high density by spontaneous formation of covalent bonds of the complexing polymer from the hydrophilic functional group as a reaction site, applying a precursor containing the same metal species as that in an intended plated layer, to the surface of the dielectric substrate by a liquid phase method, connecting the precursor to the complexing polymer through coordinate bonds, subjecting the complexing polymer film containing the metal ion introduced from the precursor, to atmospheric pressure plasma treatment using a rare gas again to reduce the metal ion into an atomic metal, and concurrently allowing the formed atomic metal to aggregate in a self-organized manner to form a nanosized cluster or to grow into metal nanoparticles. The methods further include a step of immersing the dielectric substrate having the surface on which the nanocluster or the metal nanoparticles are formed, in an electroless plating bath to form a metal layer using the metal nanoparticles as a catalyst. Therefore, the steps have been required to be simplified.

### Citation List

### Patent Literature

Patent Document 1: JP-A No. 2012-153634
Patent Document 2: JP-ANo. 2010-156022
Patent Document 3: JP-A No. 2012-062543

### Summary of the Invention

### Technical Problem

In view of the above circumstances, it is an object of the present invention, when the surface of a dielectric substrate is metallized to produce a dielectric substrate provided with a metal film, to solve the problem, such as decrease in a signal propagation speed and increase in power consumption, and also to provide a metal film that has high adhesiveness even to the surface of a dielectric substrate composed of the fluorine resin represented by PTFE for which adhesion to other substance groups is difficult due to its high chemical stability, at lower cost as compared with conventional methods.

### Solution to Problem

The inventors of the present invention have conducted intensive studies in order to achieve the object, consequently have found that a metallic silver film having high adhesiveness to the surface of a dielectric substrate composed of a fluorine resin such as PTFE, which intrinsically has low adhesiveness, can be formed by generating a peroxide radical on a dielectric substrate surface by treating the dielectric substrate surface with plasma; fixing a functional group forming a coordinate bond with a silver ion by reacting a grafting agent; and applying a silver-containing composition to the substrate surface, followed by curing the silver-containing composition, and have completed the present invention.

In other words, a method for metallizing a dielectric substrate surface of the present invention includes: generating a peroxide radical on a dielectric substrate surface by treating the dielectric substrate surface with atmospheric pressure plasma using a rare gas; fixing a functional group forming a coordinate bond with a silver ion by reacting a grafting agent on the substrate surface having the peroxide radical; and applying a silver-containing composition to the substrate surface on which the functional group forming a coordinate bond with the silver ion is fixed, followed by heating and curing the silver-containing composition, to thereby form a silver thin film layer, the silver-containing composition containing a silver compound (A) represented by Formula (1) and an amine compound (B) represented by Formula (2), the silver compound (A) being contained in an amount of 10 to 50% by mass, the amine compound (B) being contained in an amount of 50 to 90% by mass, relative to a total amount of 100% by mass of the silver compound (A) and the amine compound (B)

### [C. 1]

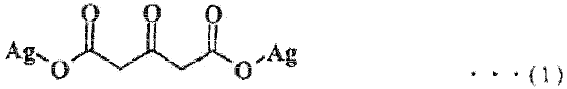

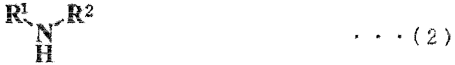

(R¹ is a hydrogen atom, -(CY₂)a-CH₃, or -((CH₂)b-O-CHZ)c-CH₃; R² is -(CY₂)d-CH₃ or -((CH₂)e-O-CHZ)f-CH₃; Y is a hydrogen atom or -(CH₂)_{g}-CH₃; Z is a hydrogen atom or -(CH₂)h-CH₃; a is an integer of 0 to 8; b is an integer of 1 to 4; c is an integer of 1 to 3; d is an integer of 1 to 8; e is an integer of 1 to 4; f is an integer of 1 to 3; g is an integer of 1 to 3; and h is an integer of 1 or 2)

In a preferred embodiment, the silver-containing composition contains the silver compound (A) and the amine compound (B) in an amount of 20 to 80% by mass and a solvent in an amount of 20 to 80% by mass.

In a preferred embodiment, the dielectric substrate is a fluorine-containing polymer resin, a polymer alloy or a copolymer of a fluorine-containing polymer resin with a liquid crystalline polymer represented by a polyester, or, a polymer alloy or a copolymer of a fluorine-containing polymer resin with a polyimide dielectric. In a further preferred embodiment, the dielectric substrate is polytetrafluoroethylene.

In another preferred embodiment, the grafting agent is composed of a complexing compound and/or a complexing polymer containing a functional group that includes an atomic group containing at least one selected from the group consisting of N, P, and S and forms a coordinate bond with a silver ion. More preferably, the complexing compound is at least one compound selected from the group consisting of vinylamines, acrylamide, acrylonitrile, vinylanilines, vinylisocyanates, vinylpyrroles, vinylpyrrolidones, vinyltriazines, vinylphosphonic acids, vinylphosphonic acids, vinylthiols, vinylthiophenes, and vinylsulfonic acids, and the complexing polymer is at least one polymer compound including polymers of the complexing compounds.

It is preferred that the grafting agent and the silver-containing composition are applied by any liquid phase method of spin coating, spraying, inkjet printing, offset printing, gravure offset printing, immersing, and doctor blade coating.

The present invention also relates to a dielectric substrate with a metal film, in which a silver thin film layer is formed on the dielectric substrate by the method for metallizing a dielectric substrate surface.

### Advantageous Effects of Invention

According to the present invention, atmospheric pressure plasma is used to form peroxide radicals on a substrate surface, and the peroxide radical groups formed on the surface of a fluorine resin substrate by atmospheric pressure plasma are used as the starting point to fix a functional group forming coordinate bonds with a silver ion in a silver-containing composition by a grafting agent. Thus, the adhesive strength of a silver thin film to the substrate surface is high. The silver-containing composition used contains the silver compound (A) and the amine compound (B) at a particular ratio. Thus, the concentration of silver in the composition can be increased, and a metallic silver film can be rapidly produced in the absence of a catalyst at a low temperature of less than 150°C. The metallic silver film can be formed at a low temperature, and thus the metallic silver film can be formed in a short time. At a high temperature of 150°C or more, the metallic silver film can be formed in a shorter time. Therefore, the productivity can be likely improved by the method. This enables the formation of a dielectric substrate provided with a metal film in which a metal film composed of a silver thin film having high adhesiveness is formed on the surface of a dielectric substrate composed of the fluorine resin such as PTFE, which provides high signal propagation speed and comparatively low power consumption, in a simpler manner at lower cost as compared with conventional methods.

### Brief Description of the Drawings

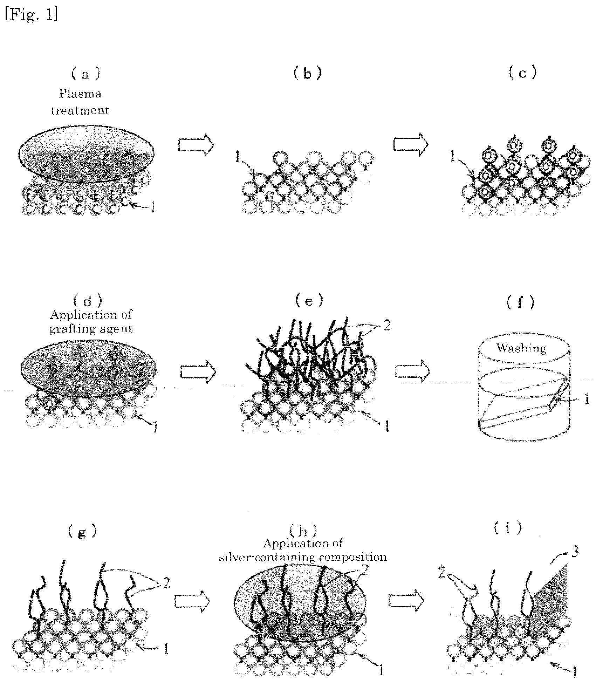

Figs. 1 are schematic diagrams showing steps and procedures of a method for metallizing a dielectric substrate surface of the present invention.

### Description of Embodiments

The present invention will be described in further detail with reference to embodiments shown in the attached drawings.

The resin substrate used as the base of a dielectric substrate of the present invention is exemplified by olefinic resins such as fluorine resins, epoxy resins, polyethylene resins, polypropylene resins, and cycloolefin resins; styrenic resins such as polystyrene resins and syndiotactic polystyrene resins; aromatic polyether ketone resins such as polyether ether ketone resins and polyphenylene ether resins; polyacetal resins; polyphenylene sulfide resins; and bismaleimide triazine resins.

The present embodiment describes an example in which a fluorine resin substrate is used as the dielectric substrate to give a printed board.

As the fluorine resin substrate used as the base, a fluorine-containing polymer resin, a polymer alloy or a copolymer of a fluorine-containing polymer resin with a liquid crystalline polymer represented by a polyester, or, a polymer alloy or a copolymer of a fluorine-containing polymer resin with a polyimide dielectric. The film thickness of the dielectric substrate composed of such a polymer film and the like is not limited to particular values. The polymer film may contain an inorganic substance such as glass cloth. In the below description, the fluorine resin is polytetrafluoroethylene (PTFE) unless otherwise specified.

Figs. 1 are schematic diagrams showing the method for metallizing a dielectric substrate surface of the present invention. Fig. 1(a) is a diagram showing a step of atmospheric pressure plasma treatment of a fluorine resin substrate 1 as a dielectric substrate. The fluorine resin substrate 1 to be a printed board is placed between two electrodes facing each other and is subjected to atmospheric pressure plasma treatment using a rare gas as the main component. Radicals, electrons, ions, and the like contained in the plasma eliminate fluorine atoms on the surface of the fluorine resin to induce the formation of dangling bonds (see Fig. 1(b)). Then, by exposing the substrate to the atmosphere for several to 10 minutes, the dangling bonds are reacted with water in the atmosphere to spontaneously form a peroxide radical group and hydrophilic functional groups such as a hydroxy group and a carbonyl group on the dangling bonds (see Fig. 1(c)). The plasma treatment and the plasma treatment apparatus may be a common method and a common apparatus, and the plasma treatment apparatus may be any of a substitution type and an atmosphere open type.

To the surface of the fluorine resin substrate 1 to which the peroxide radical group has been introduced by atmospheric pressure plasma treatment, a grafting agent is applied by a liquid phase method such as spin coating to form an ultrathin film (see Fig. 1(d)). In this step, the peroxide radical group formed on the fluorine resin surface functions as the reaction site and spontaneously forms covalent bonds with the grafting agent 2, and the grafting agent is grafted at high density from the fluorine resin surface (see Fig. 1(e)). Examples of the method for applying the grafting agent include, in addition to the spin coating, spraying, inkjet printing, offset printing, gravure offset printing, immersing, and doctor blade coating, but are not necessarily limited to them.

As the grafting agent, preferred is a compound or a polymer having such a functional group as to form coordinate bonds with metal ions, including a carbonyl group, a lower amino group (primary amino group), a higher amino group (secondary or higher amino group), an amido group, a pyridyl group, a pyrrolyl group, an imidazole group, an isocyanate group, a hydroxy group, an ether group, an ester group, a phosphoric acid group, a urea group, a thiol group, a thiophene group, and a thiourea group. More preferred is a complexing compound or a complexing polymer having a functional group that includes an atomic group containing at least one of N, P, and S and can form coordinate bonds with silver ions. Specific examples of the preferred complexing compound include, but are not necessarily limited to, vinylamines (for example, acrylic amine), acrylamide, acrylonitrile, vinylanilines, vinylisocyanates, vinylpyrroles, vinylpyrrolidones, vinyltriazines, vinylphosphonic acids, vinylphosphoric acids, vinylthiols, vinylthiophenes, and vinylsulfonic acids. Preferred examples of the complexing polymer include, but are not necessarily limited to, polymers of the above complexing compounds, such as polyvinylamines (for example, polyacrylamines), polyacrylamides, polyacrylonitriles, polyvinylanilines, polyvinylisocyanates, polyvinylpyrroles, polyvinylpyrrolidones, polyvinyltriazines, polyvinylphosphonic acids, polyvinylphosphoric acids, polyvinylthiols, polyvinylthiophenes, and polyvinylsulfonic acids. Examples of the polyacrylamine include, but are not necessarily limited to, primary amino group-containing acrylic polymers (for example, aminoethylated acrylic polymers).

Next, it is preferred that an unreacted grafting agent that is not directly bonded to the surface of the fluorine resin substrate 1 be washed and removed (see Fig. 1(f)) to improve the adhesiveness of a metal film (silver thin film layer) 3 to be finally formed (see Fig. 1(g)). This washing step may not be performed.

Then, a silver-containing composition is applied by a liquid phase method such as spin coating, yielding an ultrathin film (Fig. 1(h)). Next, the thin film of the silver-containing composition applied is heated to be cured, yielding a silver thin film layer 3 (see Fig. 1(i)).

The silver-containing composition used in the present invention contains a silver compound (A) represented by Formula (1) and an amine compound (B) represented by Formula (2) at a particular ratio.

The silver compound (A) is silver acetonedicarboxylate and is typically in powder form. The silver compound (A) has a larger viscosity when diluted in a solvent and is a substance difficult to perform patterning such as printing. If the amine compound (B) is used in combination, a composition having a high silver content can be set to have a low viscosity. In addition, the silver compound (A) alone has a high decomposition temperature, and it takes a long period of time to generate metallic silver by burning at 150°C or lower. If the amine compound (B) is used in combination, metallic silver can be generated by burning at a low temperature of 150°C or less in a short time. Moreover, the silver compound (A) and the amine compound (B) provide a synergistic effect and extremely improve the storage stability (determined by the formation of the precipitate of silver particles) as compared with when other silver carboxylates are used.

In the silver-containing composition, the content of the silver compound (A) is 10 to 50% by mass, and the content of the amine compound (B) is 50 to 90% by mass, relative to the total amount of 100% by mass of the silver compound (A) and the amine compound (B). The content of the silver compound (A) is preferably 20 to 40% by mass, and the content of the amine compound (B) is preferably 60 to 80% by mass. If the content of the amine compound (B) is less than 50% by mass, the solubility of the silver compound (A) may be greatly reduced.

The silver compound (A) as silver acetonedicarboxylate used in the present invention may be produced by any method, which is exemplified by methods described in known literature, including a method in "Journal fur Praktische Chemie. Band 312 (1970) pp. 240 to 244". In particular, when a basic substance is used to produce silver acetonedicarboxylate, an organic base is desirably used in order to prevent contamination of metal ions.

The amine compound (B) used in the present invention is a compound represented by Formula (2), where R¹ is a hydrogen atom, -(CY₂)a-CH₃, or -((CH₂)b-OCHZ)c-CH₃, and R² is a phenyl group, -(CY₂)d-CH₃, or -((CH₂)e-O-CHZ)f-CH₃. In the formula, Y is a hydrogen atom or -(CH₂)g-CH₃, and Z is a hydrogen atom or -(CH₂)h-CH₃. a is an integer of 0 to 8; b is an integer of 1 to 4; c is an integer of 1 to 3; d is an integer of 1 to 8; e is an integer of 1 to 4; f is an integer of 1 to 3; g is an integer of 1 to 3; and h is an integer of 1 or 2.

The amine compound (B) is exemplified by ethylamine, 1-propylamine, 1-butylamine, 1-pentylamine, 1-hexylamine, 1-heptylamine, 1-octylamine, 2-ethylhexylamine, isopropylamine, isobutylamine, isopentylamine, sec-butylamine, tert-butylamine, tert-amylamine, benzylamine, 3-methoxypropylamine, 2-ethoxypropylamine, 3-isopropoxypropylamine, diisopropylamine, dibutylamine, and 2-ethoxyethylamine. These compounds may be used singly or in combination of two or more of them. In the below description, the expression of "1-" in "1-propylamine" may not be expressed, and "1-propylamine" is also simply expressed as "propylamine", for example.

When the silver-containing composition used in the present invention is applied to, for example, reflective electrodes that are required to have light reflecting performance, a metallic silver film to be produced is required to have higher flatness (smoothness). When the composition is used for such an application, R¹ in the amine compound (B) is preferably a hydrogen atom, -(CY₂)a-CH₃, or -((CH₂)b-O-CHZ)c-CH₃, Y and Z are each particularly preferably a hydrogen atom or a methyl group, a is particularly preferably an integer of 2 to 6, b is particularly preferably an integer of 1 to 3, and c is particularly preferably 1 or 2. Similarly, R² is desirably -(CY₂)d-CH₃ or -((CH₂)e-O-CHZ)f-CH₃, Y and Z are each desirably a hydrogen atom, d is desirably an integer of 1 to 6, e is desirably an integer of 1 to 3, and f is desirably an integer of 1 or 2. When low temperature sinterability at lower than 150°C is exerted, an amine compound (B) having a boiling point of less than 130°C is more preferably used. Examples of the amine compound (B) satisfying such conditions preferably include 1-propylamine, 1-butylamine, 1-pentylamine, 1-hexylamine, 1-heptylamine, 1-octylamine, isopropylamine, isobutylamine, isopentylamine, 3-methoxypropylamine, 2-ethoxypropylamine, 2-ethoxyethylamine, 3-isopropoxypropylamine, diisopropylamine, dibutylamine, and 2-ethylhexylamine. These compounds may be used singly or in combination of two or more of them.

To the silver-containing composition used in the present invention, a solvent can be appropriately added in addition to the silver compound (A) and the amine compound (B) in order to improve the coatability on a substrate or to adjust the viscosity. The amount of the solvent is preferably 20 to 80% by mass where the total amount of the silver compound (A) and the amine compound (B) is 20 to 80% by mass. The amount of the solvent is more preferably 40 to 60% by mass where the total amount of the silver compound (A) and the amine compound (B) is 40 to 60% by mass. If the amount of the solvent is more than 80% by mass, the silver content is reduced, causing a possibility in which a uniform silver film cannot be obtained to occur.

Types of the solvent are not particularly limited, but is preferably such a solvent as to be easily removed when a silver film is produced. Examples of the type of the solvent include alcohols such as methanol, ethanol, 1-propanol, 2-propanol, 1-butanol, 2-butanol, tert-butanol, 1-pentanol, 2-pentanol, 3-pentanol, 1-hexanol (n-hexyl alcohol), tert-amyl alcohol, ethylene glycol, butoxyethanol, methoxyethanol, ethoxyethanol, propylene glycol, propylene glycol monomethyl ether, propylene glycol monopropyl ether, propylene glycol monobutyl ether, and dipropylene glycol monomethyl ether; ethers such as acetoxymethoxypropane, phenyl glycidyl ether, and ethylene glycol glycidyl ether : ketones such as acetone, methyl ethyl ketone, and methyl isobutyl ketone; nitriles such as acetonitrile, propionitrile, butyronitrile, and isobutyronitrile; sulfoxides such as DMSO; water; and 1-methyl-2-pyrrolidone. These solvents may be used singly or as a mixture according to an application.

In terms of flatness and low temperature sinterability of a silver film to be formed, preferred solvents are ethanol, 1-propanol, 2-propanol, 1-butanol, 2-butanol, 1-pentanol, tert-amyl alcohol, ethylene glycol, butoxyethanol, methoxyethanol, ethoxyethanol, propylene glycol, propylene glycol monomethyl ether, propylene glycol monopropyl ether, propylene glycol monobutyl ether, dipropylene glycol monomethyl ether, methyl ethyl ketone, methyl isobutyl ketone, acetonitrile, propionitrile, butyronitrile, and isobutyronitrile. These solvents may be used singly or as a mixture of two or more of them.

When such a solvent is used, the addition order is especially not limited. For example, a solvent can be added to a mixture of the silver compound (A) and the amine compound (B). Alternatively, the silver compound (A) can be added to a mixture of the amine compound (B) and a solvent, or the amine compound (B) can be added to a mixture of the silver compound (A) and a solvent.

The silver-containing composition used in the present invention may contain an additional component such as hydrocarbons, acetylene alcohols, and silicone oil for adjusting leveling properties on a substrate, a coupling agent such as a silane coupling agent for adjusting the adhesiveness to a substrate, an additive such as a resin and a plasticizer for adjusting viscosity properties, additional electric conductor powders, glass powders, surfactants, metal salts, and other additives commonly used in similar liquid compositions, as necessary.

In order to further shorten the sintering time, the silver-containing composition used in the present invention may be warmed in advance or may be reacted with a commonly known reducing agent to form silver clusters and nanoparticles, and a resulting silver colloidal dispersion liquid can be used. In this case, a borohydride compound, a tertiary amine, a thiol compound, a phosphorus compound, ascorbic acid, a quinone, a phenol, or a similar compound can be added as the reducing agent in such an amount as not to impair electric conductivity or flatness.

The silver-containing composition of the present invention can be applied to a substrate by spin coating or printing, for example. Examples of the coating method include, but are not necessarily limited to, spraying, inkjet printing, offset printing, gravure offset printing, immersing, and doctor blade coating.

The heating temperature upon heating a substrate coated with the silver-containing composition may be any temperature that is equal to or higher than room temperature. In consideration of productivity, heating at 80°C or higher is preferred for burning in a short time. When a metallic silver film or silver wiring is formed on a resin substrate having low heat resistance, the burning is preferably performed at a temperature of not less than 80°C and less than 150°C. When a substrate having excellent heat resistance, such as a fluorine resin, is used, the burning is preferably performed at a temperature of not less than 120°C and less than 170°C from the viewpoint of productivity.

### Examples

First, production examples of silver-containing inks which contain the silver-containing composition used in the present invention will be described.

### (Synthesis Example) Synthesis of silver acetonedicarboxylate (silver salt A)

In a 1,000-ml beaker, 43.8 g of acetonedicarboxylic acid was weighed, and then 600 g of ion-exchanged water was added to dissolve the acid. The solution was cooled on ice, and 102 g of silver nitrate was further added and dissolved. To the solution, 48 g of hexylamine was added, and the mixture was stirred for 30 minutes. The resulting white solid was collected by filtration, then washed with acetone, and dried under reduced pressure, giving 88.2 g of silver acetonedicarboxylate as a white solid (yield: 82%). The obtained silver acetonedicarboxylate was subjected to TGA analysis with a thermogravimetric analyzer (manufactured by SII NanoTechnology Inc.). As for the analysis conditions, the temperature increase rate was 10°C/min, and the measurement atmosphere was in air. As a result, the thermal decomposition temperature was 175°C. The residue after the thermogravimetric analysis was 59.7%, which was in agreement with the theoretical residual ratio (59.4%).

### (Production Example 1: Production of silver-containing ink 1)

In a light shielding bottle, 200 mg of the silver acetonedicarboxylate prepared in Synthesis Example was dissolved in 800 mg of hexylamine (HA) to give a silver-containing composition. In a light shielding bottle, 800 mg of the obtained silver acetonedicarboxylate-containing amine solution was added to 200 mg of isopropyl alcohol (IPA) to yield a silver-containing ink solution 1.

### (Production Example 2: Production of silver-containing ink 2)

In a light shielding bottle, 400 mg of the silver acetonedicarboxylate prepared in Synthesis Example was dissolved in 600 mg of hexylamine (HA) to give a silver acetonedicarboxylate-containing amine solution. In a light shielding bottle, 400 mg of the obtained silver acetonedicarboxylate-containing amine solution was added to 600 mg of isopropyl alcohol (IPA) to yield a silver-containing ink solution 2.

### (Production Example 3: Production of silver-containing ink 3)

In a light shielding bottle, 400 mg of the silver acetonedicarboxylate prepared in Synthesis Example was dissolved in 600 mg of butylamine (BA) to give a silver acetonedicarboxylate-containing amine solution. In a light shielding bottle, 400 mg of the obtained silver acetonedicarboxylate-containing amine solution was added to 600 mg of isopropyl alcohol (IPA) to yield a silver-containing ink solution 3.

### (Production Example 4: Production of silver-containing ink 4)

In a light shielding bottle, 400 mg of the silver acetonedicarboxylate prepared in Synthesis Example was dissolved in 600 mg of propylamine (PA) to give a silver acetonedicarboxylate-containing amine solution. In a light shielding bottle, 400 mg of the obtained silver acetonedicarboxylate-containing amine solution was added to 600 mg of isopropyl alcohol (IPA) to yield a silver-containing ink solution 4.

### (Production Example 5: Production of silver-containing ink 5)

In a light shielding bottle, 400 mg of the silver acetonedicarboxylate prepared in Synthesis Example was dissolved in 600 mg of dibutylamine (DBA) to give a silver acetonedicarboxylate-containing amine solution. In a light shielding bottle, 400 mg of the obtained silver acetonedicarboxylate-containing amine solution was added to 600 mg of isopropyl alcohol (IPA) to yield a silver-containing ink solution 5.

### (Production Example 6: Production of silver-containing ink 6)

In a light shielding bottle, 400 mg of the silver acetonedicarboxylate prepared in Synthesis Example was dissolved in 600 mg of 2-ethoxyethylamine (2-EOEA) to give a silver acetonedicarboxylate-containing amine solution. In a light shielding bottle, 400 mg of the obtained silver acetonedicarboxylate-containing amine solution was added to 600 mg of isopropyl alcohol (IPA) to yield a silver-containing ink solution 6.

### (Production Example 7: Production of silver-containing ink 7)

In a light shielding bottle, 400 mg of the silver acetonedicarboxylate prepared in Synthesis Example was dissolved in 600 mg of 2-ethylhexylamine (2-EHA) to give a silver acetonedicarboxylate-containing amine solution. In a light shielding bottle, 400 mg of the obtained silver acetonedicarboxylate-containing amine solution was added to 600 mg of isopropyl alcohol (IPA) to yield a silver-containing ink solution 7.

### (Production Example 8: Production of silver-containing ink 8)

In a light shielding bottle, 400 mg of the silver acetonedicarboxylate prepared in Synthesis Example was dissolved in 600 mg of hexylamine (HA) to give a silver acetonedicarboxylate-containing amine solution. In a light shielding bottle, 400 mg of the obtained silver acetonedicarboxylate-containing amine solution was added to 600 mg of propylene glycol monomethyl ether (PGM) to yield a silver-containing ink solution 8.

### (Production Example 9: Production of silver-containing ink 9)

In a light shielding bottle, 400 mg of the silver acetonedicarboxylate prepared in Synthesis Example was dissolved in 600 mg of hexylamine (HA) to give a silver acetone dicarboxylate-containing amine solution. In a light shielding bottle, 400 mg of the obtained silver acetonedicarboxylate-containing amine solution was added to 600 mg of n-hexyl alcohol (n-HA) to yield a silver-containing ink solution 9.

### (Production Example 10: Production of silver-containing ink 10)

In a light shielding bottle, 400 mg of the silver acetonedicarboxylate prepared in Synthesis Example was dissolved in 600 mg of hexylamine (HA) to give a silver acetonedicarboxylate-containing amine solution. In a light shielding bottle, 400 mg of the obtained silver acetonedicarboxylate-containing amine solution was added to 600 mg of tert-amyl alcohol (TAA) to yield a silver-containing ink solution 10.

### (Production Example 11: Production of silver-containing ink 11)

In a light shielding bottle, 400 mg of the silver acetonedicarboxylate prepared in Synthesis Example was dissolved in 200 mg of 2-ethylhexylamine (2-EHA) and 400 mg of 2-ethoxyethylamine (2-EOEA) to give a silver acetonedicarboxylate-containing amine solution. In a light shielding bottle, 400 mg of the obtained silver acetonedicarboxylate-containing amine solution was added to 600 mg of methanol (MeOH) to yield a silver-containing ink solution 11.

Next, specific examples of the method for metallizing a dielectric surface pertaining to the present invention and the dielectric substrate provided with a metal film produced by the method will be described.

### (Example 1)

By the following procedure, a PTFE dielectric substrate having a surface on which a metal film composed of a silver thin film was formed was produced. The resin substrate used was a PTFE sheet shaved into a thickness of 0.2 mm, manufactured by Nitto Denko Corporation. The grafting agent used was an aminoethylated acrylic polymer having an amino group.

### (I) Preparation

1) A PTFE sheet was cut into a predetermined size (a rectangular shape with dimensions of 20 mm × 50 mm).
2) The cut PTFE sheet was placed in a beaker containing acetone and was sonicated for 1 minute.
3) The PTFE sheet after the ultrasonic cleaning in acetone in 2) was placed in a beaker containing ultrapure water and was sonicated for 1 minute.
4) To the PTFE sheet after the ultrasonic cleaning in ultrapure water in 3), nitrogen gas (purity: 99% or more) was blown to release and remove ultrapure water.

### (II) Atmospheric pressure plasma treatment

5) A curing tape (manufactured by Sekisui Chemical Co., Ltd.) was attached to each end of the PTFE sheet after the ultrasonic cleaning, and the PTFE sheet was fixed under the electrode of a plasma treatment apparatus.
6) The plasma treatment was performed with a direct current pulse power source in conditions of an input voltage of 5 kVₚ₋ᵥ, a plasma treatment time of 20 minutes, and a gap between the electrode and the sample table of 1.5 mm while Ar gas was allowed to flow as the process gas at a flow rate of 3 slm.

The plasma treatment apparatus used was a normal pressure plasma surface treatment apparatus (AP-T05-L150) manufactured by Sekisui Chemical Co., Ltd.

### (III) Surface grafting

7) As the grafting agent, a solution of an aminoethylated acrylic polymer diluted with ultrapure water at 10 wt% (Polyment (registered trademark), NK-100PM, manufactured by Nippon Shokubai Co., Ltd.) was used. In the example, the surface grafting was performed by immersing the PTFE sheet after plasma treatment in the aminoethylated acrylic polymer for 20 seconds.
8) In order to remove an unreacted grafting agent on the PTFE sheet, the surface-grafted PTFE sheet was placed in a beaker containing ultrapure water and was sonicated for 10 minutes.
9) To the PTFE sheet after the ultrasonic cleaning, nitrogen gas (purity: 99% or more) was blown by an air gun to release and remove ultrapure water.

### (IV) Formation of silver thin film layer

10) Onto the surface-grafted PTFE sheet, the silver-containing ink 7 produced in Production Example 7 was applied by spin coating. The spin coating was performed in conditions of a rotation rate of 1,000 rpm and a rotation time of 10 seconds.
11) The silver-containing ink was cured by heat treatment of the PTFE sheet coated with the silver-containing ink in conditions of a heating temperature of 120°C and a heating time of 20 minutes. This treatment gave a dielectric substrate provided with a metal film in which a metal film composed of a silver thin film was formed on the PTFE surface.

### (V) Adhesive strength test

12) The adhesive strength between the silver thin film and the PTFE sheet in the obtained dielectric substrate provided with a metal film was evaluated by the 90° peel test in accordance with JIS K6854-1. A two-liquid mixing type epoxy adhesive (main agent: EPOXY RESIN AV138, curing agent: HARDENER HV998, mass ratio: main agent/curing agent = 2.5/1) manufactured by Nagase ChemteX Corporation was applied to a stainless steel rod, and the silver thin film was brought into contract with the adhesive. The adhesive was cured in conditions of a heating temperature of 80°C and a heating time of 30 minutes. As the tensile tester, a digital force gauge (ZP-200N) and an electric stand (MX-500N) manufactured by Imada Co., Ltd. were used. An end of the PTFE sheet was clamped with a clip, and the tensile test was performed at 1 mm/sec. In the example, the resulting adhesive strength was 0.60 N/mm.

### (Comparative Example 1)

A silver thin film was formed on the surface of a PTFE sheet in the same manner as in Example 1 except that the steps of 5) to 9) in Example 1 were not performed to eliminate (II) the plasma treatment and (III) the grafting, giving a dielectric substrate provided with a metal film. The adhesive strength between the silver thin film and the PTFE sheet in the obtained PTFE sheet with a metal film was determined in the same manner as in Example 1, resulting in an adhesive strength of 0.0 N/mm. The silver thin film was easily released from the PTFE sheet.

### (Comparative Example 2)

The surface of a PTFE sheet was subjected to plasma treatment to form a silver thin film in the same manner as in Example 1 except that the steps of 7) to 9) in Example 1 were not performed to eliminate (III) the grafting, giving a dielectric substrate provided with a metal film. The adhesive strength between the silver thin film and the PTFE sheet in the obtained PTFE sheet with a metal film was determined in the same manner as in Example 1, resulting in an adhesive strength of 0.32 N/mm.

The results of Example 1 and Comparative Examples 1 and 2 revealed that the adhesive strength between a silver thin film and a PTFE sheet was markedly improved by subjecting the surface of a PTFE sheet as a dielectric substrate to plasma treatment and grafting, then applying a silver-containing composition, and heating and curing the composition.

### (Example 2)

A dielectric substrate having a surface on which a metal film composed of a silver thin film was formed was produced in the same procedure as in Example 1 except that a polyimide (PI) sheet was used as the resin substrate in place of the PTFE sheet in Example 1, and the adhesive test of the metal film was performed. The PI resin substrate used was "Kapton (registered trademark) H300, manufactured by DU PONT-TORAY Co., Ltd.". The grafting agent used was the same aminoethylated acrylic polymer having an amino group as in Example 1.

As a result of the adhesive test, the PI resin substrate was broken, and it was ascertained that the adhesion force between the metal film and the resin substrate was higher than the breaking strength of the resin substrate itself. The breaking strength of the PI resin substrate itself was determined to be 17.2 N/mm.

### (Example 3)

A dielectric substrate having a surface on which a metal film composed of a silver thin film was formed was produced in the same procedure as in Example 1 except that a cycloolefin polymer (COP) sheet was used as the resin substrate in place of the PTFE sheet in Example 1, and the adhesive test of the metal film was performed. The COP sheet used was "ZEONORFILM (registered trademark) ZF-16-100, manufactured by Zeon Corporation". The grafting agent used was the same aminoethylated acrylic polymer having an amino group as in Example 1.

As a result of the adhesive test, the COP resin substrate was broken, and it was ascertained that the adhesion force between the metal film and the resin substrate was higher than the breaking strength of the resin substrate itself. The breaking strength of the COP resin substrate itself was determined to be 6.0 N/mm.

### Reference Signs List

- 1: Fluorine resin substrate
- 2: Grafting agent
- 3: Metal film (silver thin film layer)

## Claims

1. A method for metallizing a dielectric substrate surface, the method comprising:
generating a peroxide radical on a dielectric substrate surface by treating the dielectric substrate surface with atmospheric pressure plasma using a rare gas;
fixing a functional group forming a coordinate bond with a silver ion, by reacting a grafting agent on the substrate surface having the peroxide radical; and
applying a silver-containing composition to the substrate surface on which the functional group forming the coordinate bond with the silver ion is fixed, followed by heating and curing the silver-containing composition, to thereby form a silver thin film layer, the silver-containing composition containing a silver compound (A) represented by Formula (1) and an amine compound (B) represented by Formula (2), the silver compound (A) being contained in an amount of 10 to 50% by mass, the amine compound (B) being contained in an amount of 50 to 90% by mass, relative to a total amount of 100% by mass of the silver compound (A) and the amine compound (B) [C. 1] 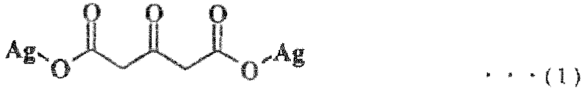 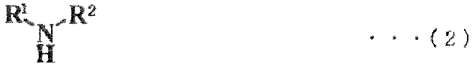 (R¹ is a hydrogen atom, -(CY₂)a-CH₃, or -((CH₂)b-O-CHZ)c-CH₃; R² is -(CY₂)d-CH₃ or -((CH₂)e-O-CHZ)f-CH₃; Y is a hydrogen atom or -(CH₂)g-CH₃; Z is a hydrogen atom or -(CH₂)h-CH₃; a is an integer of 0 to 8; b is an integer of 1 to 4: c is an integer of 1 to 3; d is an integer of 1 to 8; e is an integer of 1 to 4; f is an integer of 1 to 3; g is an integer of 1 to 3; and h is an integer of 1 or 2).

2. The method for metallizing a dielectric substrate surface according to claim 1, wherein the silver-containing composition contains the silver compound (A) and the amine compound (B) in an amount of 20 to 80% by mass and a solvent in an amount of 20 to 80% by mass.

3. The method for metallizing a dielectric substrate surface according to claim 1 or 2, wherein the dielectric substrate is a fluorine-containing polymer resin, a polymer alloy or a copolymer of a fluorine-containing polymer resin with a liquid crystalline polymer represented by a polyester, or, a polymer alloy or a copolymer of a fluorine-containing polymer resin with a polyimide dielectric.

4. The method for metallizing a dielectric substrate surface according to claim 1 or 2, wherein the dielectric substrate is polytetrafluoroethylene.

5. The method for metallizing a dielectric substrate surface according to any one of claims 1 to 4, wherein the grafting agent is composed of a complexing compound and/or a complexing polymer, containing a functional group that includes an atomic group containing at least one selected from the group consisting of N, P, and S and that forms a coordinate bond with a silver ion.

6. The method for metallizing a dielectric substrate surface according to claim 5, wherein the complexing compound is at least one compound selected from the group consisting of vinylamines, acrylamide, acrylonitrile, vinylanilines, vinylisocyanates, vinylpyrroles, vinylpyrrolidones, vinyltriazines, vinylphosphonic acids, vinylphosphoric acids, vinylthiols, vinylthiophenes, and vinylsulfonic acids, and the complexing polymer is at least one polymer compound including polymers of the complexing compounds.

7. The method for metallizing a dielectric substrate surface according to any one of claims 1 to 6, wherein the grafting agent and the silver-containing composition are applied by any liquid method of spin coating, spraying, inkjet printing, offset printing, gravure offset printing, immersing, and doctor blade coating.

8. A dielectric substrate with a metal film, wherein a silver thin film layer is formed on the dielectric substrate by the method for metallizing a dielectric substrate surface according to any one of claims 1 to 7.
